# EUROPÄISCHE PATENTSCHRIFT

(11) **EP 2 803 082 B1**
(45) Veröffentlichungstag und Bekanntmachung des Hinweises auf die Patenterteilung: **03.02.2016**
(21) Anmeldenummer: 12798672.7
(22) Anmeldetag: 29.11.2012
(51) Int. Cl.: H01L 23/053, H01L 23/26

(54) **ELEKTRONISCHES BAUTEIL MIT KORROSIONSGESCHÜTZTER BONDVERBINDUNG UND VERFAHREN ZUR HERSTELLUNG DES BAUTEILS**
ELECTRONIC COMPONENT HAVING A CORROSION-PROTECTED BONDING CONNECTION AND METHOD FOR PRODUCING THE COMPONENT
COMPOSANT ÉLECTRONIQUE DOTÉ D'UNE LIAISON DE CONNEXION PROTÉGÉE CONTRE LA CORROSION ET PROCÉDÉ DE FABRICATION DU COMPOSANT

(30) Priorität: 11.01.2012 DE 102012200273
(43) Veröffentlichungstag der Anmeldung: 19.11.2014
(73) Patentinhaber: Robert Bosch GmbH, 70442 Stuttgart (DE)
(72) Erfinder: DUERR, Johannes, 72770 Reutlingen (DE); BECKER, Rolf, 72793 Pfullingen (DE); LAMERS, Sven, 72764 Reutlingen (DE); MUELLER, Lutz, 72631 Aichtal (DE); BEZ, Fabian, 72138 Kirchentelinsfurt (DE); SCHLECHT, Michael, 72141 Walddorfhaeslach (DE)
(86) Internationale Anmeldenummer: PCT/EP2012/073971
(87) Internationale Veröffentlichungsnummer: WO 2013/104460

(56) Entgegenhaltungen:
- EP-A1- 0 113 282
- EP-A1- 2 400 540
- DE-A1- 10 049 556
- JP-A- 59 038 643
- JP-A- 2007 231 453
- US-A- 4 382 327

## Beschreibung

### Stand der Technik

Die Erfindung betrifft ein elektronisches Bauteil mit korrosionsgeschützter Bondverbindung und ein Verfahren zur Herstellung desselben. Dazu weist das elektronische Bauteil mindestens einen Halbleiterchip auf einem Substrat auf. Ferner ist eine korrosionsgefährdete Bondverbindung auf dem Halbleiterchip vorgesehen. Als Einkapselung des mindestens einen Halbleiterchips und der mindestens einen korrosionsgefährdeten Bondverbindung sind diese von einem hermetisch einschließenden Gehäuse umgeben.

Aus der Druckschrift DE10 2008 025 599 A1 sind dazu gehäuste aktive Mikrostrukturen mit Direktkontaktierung zu einem Substrat bekannt. Dazu weist ein mikrostrukturiertes Bauteil aktive Mikrobauelemente, ein Substrat sowie Halbleiterschaltungen auf. Auf dem Substrat ist mindestens ein Gehäuse angeordnet mit einer oder mehreren darin befindlichen aktiven Mikrostrukturen, wobei mindestens eine der aktiven Strukturen durch das sie umgebende Gehäuse hindurch elektrisch an eine elektrische Leiterbahn des Substrats ankontaktiert ist. Das Gehäuse besteht dazu aus einem Bodenelement und einem Deckelement, zwischen denen sich die aktiven Strukturen befinden, wobei das Bodenelement mit dem Deckelement über einen Versiegelungsrahmen verbunden sind. Das Bodenelement und/oder das Deckelement können Vertiefungen aufweisen, in denen ein Gettermaterial angeordnet ist, das bei Aktivierung in definierbarer Weise Gasmoleküle aufnimmt und damit die Gasatmosphäre in dem Gehäuse verändert. Das Gettermaterial kann dazu dienen, Feuchtigkeit zu absorbieren oder Partikel einzufangen. Bei den Kontaktstellen zu den Halbleiterschaltungen kann es sich um Bondflächen handeln.

Aus der Druckschrift DE 196 03 746 A1 ist ein elektrolumineszierendes Schichtsystem bekannt, das innerhalb des Schichtsystems eine Getterschicht aus einem Gettermetall oder aus einem hykroskopischen Polymer aufweist. Das hygroskopische Polymer weist eine Mischung eines Binderpolymers und einer pulverförmigen hygroskopischen Substanz auf. Die Getterschicht gewährleistet, dass keinerlei Reste von Sauerstoff und/oder Wasser zu dem elektrolumineszierenden Schichtsystem gelangen kann.

Die Verhältnisse bei einem elektronischen Bauteil, das einen Innenraum oder Hohlraum in einem Gehäuse aufweist, in dem unverkapselte Halbleiterbauelemente auf einem Substrat angeordnet sind und in denen Bonddrahtverbindungen auf einem Halbleiterchip der Atmosphäre dieses Innenraums bzw. Hohlraums ausgesetzt sind, sind nicht vergleichbar mit dichtgepackten Schichtsystem, insbesondere dann, wenn Gold-Aluminium-Dünndraht-Bondverbindungen in dem hermetisch abgeschlossenen Gehäuse zu schützen sind, die in dem Schichtsystem weder vorhanden noch zu schützen sind.

Bekannt ist hingegen, dass bei Verwendung von Silikonen im Innern eines hermetisch einschließenden Gehäuses bei höheren Temperaturen ohne Schutzgasvorkehrungen Wasser entstehen kann. In Verbindung mit kleinsten Mengen an Halogeniden kann das Wasser einen Elektrolyten bilden, der zur Korrosion von Gold-Aluminium-Phasen in Gold-Aluminium-Dünndraht-Bondverbindungen beiträgt und damit zum vorzeitigen Ausfall derartiger Bonddrahtverbindungen führen kann, was die Lebensdauer des elektronischen Bauteils vermindert. In derartigen Fällen werden auch hermetisch abgeschlossene Elektronikverpackungen mit Schutzgas in Form von Helium oder Stickstoff gasdicht befüllt, um den Korrosionsvorgang zu verlangsamen und somit die Lebensdauer derartiger elektronischer Bauteile zu erhöhen.

Zusätzlich können Gettermetallschichten zur Bindung reaktiver Gase in hermetischen Gehäusen vorgesehen werden, wobei geeignete Gettermetalle wie beispielsweise Kalzium, Lithium oder Strontium aus der Druckschrift DE 196 03 746 A1 bekannt sind. Derartige Gettermaterialien selbst oder deren Bereitstellung in Getterschichten durch Aufdampfen, Sputtern oder thermisches Aktivieren sind relativ teuer und auch relativ kompliziert zu handhaben. Eine weitere Alternative korrosionsgeschützte Bondverbindungen bereitzustellen, besteht darin, edelmetallhaltige Schutzschichten auf die Aluminium-Metalllegierungen des Halbleiterchips aufzubringen.

In der Durckschrift DE 100 49 556 A1 wird ein Getter aus Titan verwendet, wobei eine Schicht aus Palladium verhindert, dass sich an der Außenseite des Getters Oxid bildet.

### Offenbarung der Erfindung

Erfindungsgemäß wird ein elektronisches Bauteil mit korrosionsgeschützter Bondverbindung und ein Verfahren zur Herstellung desselben bereitgestellt. Dazu weist das elektronische Bauteil mindestens einen Halbleiterchip auf einem Substrat auf. Ferner ist eine korrosionsgefährdete Bondverbindung auf dem Halbleiterchip vorgesehen. Als Einkapselung des mindestens einen Halbleiterchips und der mindestens einen korrosionsgefährdeten Bondverbindung sind diese von einem hermetisch einschließenden Gehäuse umgeben. Die hermetisch eingeschlossene Bondverbindung ist eine Bonddrahtverbindung, die vollständig und das Substrat mindestens teilweise in das Gehäuse mit eingeschlossen sind. Das Substrat weist in dem Gehäuse mindestens ein oberflächenmontiertes hydrolyseempfindliches Bauelement auf.

Durch das Einbringen eines hydrolyseempfindlichen Bauelements kann der Wasseranteil in der Gasatmosphäre des hermetisch geschlossenen Gehäuses durch Hydrolyse eines hydrolyseempfindlichen Materials des hydrolyseempfindlichen Bauelements soweit reduziert werden, dass Wasser für die Bildung von Elektrolyten nicht mehr in ausreichender Menge zur Korrosion der korrosionsgefährdeten Bonddrahtverbindungen zur Verfügung steht.

In einer weiteren Ausführungsform der Erfindung weist das hydrolyseempfindliche Bauelement eine Oberseite, eine Unterseite und eine zwischen Oberseite und Unterseite angeordnete Randfläche auf, wobei die Unterseite des hydrolyseempfindlichen Bauelements mindestens eine oberflächenmontierbare Molekularlage aufweist. Diese oberflächenmontierbare Molekularlage kann Bestandteil eines Klebstoffes oder eine Molekularlage des hydrolyseempfindlichen Materials des hydrolyseempfindlichen Bauelements sein.

Weiterhin ist es vorgesehen, dass das hydrolyseempfindliche Bauelement ein hydrolyseempfindliches Kernmaterial aufweist, das Wassermoleküle einer Atmosphäre eines Innenraums des Gehäuses gettert. Das Kernmaterial des hydrolyseempfindlichen Bauelements kann zusätzlich eine semipermeable Beschichtung mindestens auf der Oberseite und der Randfläche des hydrolyseempfindlichen Bauelements aufweisen. Die semipermeable Beschichtung stützt die Form des hydrolyseempfindlichen Bauelements und ist für Wassermoleküle permeabel.

In einer weiteren Ausführungsform der Erfindung ist es vorgesehen, dass das hydrolyseempfindliche Bauelement einen hydrolyseempfindlichen Kunststoff aufweist. Der hydrolyseempfindliche Kunststoff kann ein hydrolyseempfindliches Polymer sein, das bei seiner Hydrolyse dem Innenraum des Gehäuses Wassermoleküle entzieht. Dabei wird der hydrolyseempfindliche Kunststoff einer intensiven Verseifung durch die Hydrolyse bei Überschreiten einer Glasübergangstemperatur des Kunststoffs ausgesetzt. Eine Verseifung durch Hydrolyse ist die Umkehrreaktion einer Veresterung eines Kunststoffes, sodass als Kunststoff ein hydrolyseempfindlicher Polyester vorgesehen werden kann, der vorzugsweise ein hydrolyseempfindliches Polybutylenterephthalat aufweisen kann.

Ein Verfahren zur Herstellung eines elektronischen Bauteils mit mindestens einer korrosionsgeschützten Bondverbindung weist die nachfolgenden Verfahrenschritte auf. Zunächst wird mindestens ein Halbleiterchip hergestellt. Dieser Halbleiterchip wird auf ein Substrat aufgebracht. Dann wird mindestens eine Bonddrahtverbindung zwischen dem mindestens einen Halbleiterchip und dem Substrat hergestellt. Außerdem wird ein Oberflächenmontieren mindestens eines Bauelements mit einem hydrolyseempfindlichen Material auf dem Substrat durchgeführt. Danach kann ein hermetisches Einkapseln des mindestens einen Halbleiterchips, der mindestens einen Bonddrahtverbindung, des mindestens einen Bauelements mit dem hydrolyseempfindlichen Material und mindestens teilweise des Substrats in ein Gehäuse durchgeführt werden. Abschließend erfolgt ein Tempern des elektronischen Bauteils bei einer Temperatur über einer Glasumwandlungstemperatur des hydrolyseempfindlichen Materials unter Gettern von Wassermolekülen einer Atmosphäre eines Innenraums des Gehäuses. Dabei kann dieses Tempern auch während des Betriebs des Bauteils erfolgen, wenn die Umgebungstemperaturen des Einsatzortes des Bauteils wie beispielsweise in einem Motorraum eines Kraftfahrzeugs über der Glasumwandlungstemperatur des hydrolyseempfindlichen Materials liegen.

Beim Aufbringen des mindestens einen Halbleiterchips auf ein Substrat kann auch gleichzeitig das Aufbringen des mindestens einen Bauelements mit dem hydrolyseempfindlichen Material erfolgen, wenn beides über ein stoffschlüssiges Verbinden beispielsweise durch eine Klebstoffschicht auf dem Substrat erfolgen soll. Wenn außerdem die Zuleitungen zu dem elektronischen Bauteil über Durchführungen durch das Gehäuse erfolgen, kann das Substrat nicht nur teilweise sondern auch vollständig in dem hermetisch geschlossenen Gehäuse untergebracht werden. Dabei kann das hermetisch geschlossene Gehäuse aus einem Gehäuseunterteil und einem Gehäusedeckel mit dazwischen angeordnetem gasdichten Verbindungselement zusammengesetzt sein.

### Vorteile der Erfindung

Mit einem derartigen elektronischen Bauteil ist der Vorteil verbunden, dass die korrosionsempfindlichen Bonddrahtverbindungen korrosionsgeschützt werden, die einerseits Goldlegierungsdrähte mit goldbeschichteten Kontaktflächen von beispielsweise Kupferleiterbahnen auf dem Substrat verbinden, und andererseits auf dem Halbleiterchip angeordnete Bondverbindungen des Goldlegierungsdrahtes mit Aluminium-Kontaktflächen auf dem Halbleiterchip herstellen. Dieser Korrosionsschutz wird in vorteilhafter Weise dadurch erreicht, dass durch das auf dem Substrat angeordnete elektrolyseempfindliche Bauelement die Atmosphäre in dem hermetisch geschlossenen Gehäuse an Wassermolekülen derart verarmt, dass halogene Reste in der Atmosphäre des geschlossenen Gehäuses keine korrosiven Elektrolyte mehr bilden können.

Auf ein Befüllen des hermetisch geschlossenen Gehäuses mit teuren Edelgasen oder Inertgasen kann damit vollständig verzichtet werden. Außerdem vereinfacht sich die Herstellung des Bauteils, da lediglich auf dem Substrat das erfindungsgemäß vorgesehene oberflächenmontierbare elektrolyseempfindliche Bauelement zu fixieren ist. Die semipermeable Beschichtung auf der Oberseite und der Randfläche des elektrolyseempfindlichen Bauelements hat darüber hinaus den Vorteil, dass die durch eine Verseifung der Veresterungen eines Polyesters wie dem Polybutylenterephthalat entstehende Substanz auf das Volumen des hydrolyseempfindlichen Bauelements beschränkt bleibt und sich nicht in dem Innenraum des Gehäuses ausbreiten kann. Das Vorsehen einer adhäsiven Molekularlage beispielsweise einer Klebstoffschicht für die Oberflächenmontage des hydrolyseempfindlichen Bauelements hat den Vorteil, dass eine dauerhafte Fixierung der entstehenden verseiften Substanz auf die Größe der Klebstoffschicht begrenzt bleibt.

Insbesondere hat das Bauteil den Vorteil, dass die Lebensdauer der Gold-AluminiumVerbindung der Bonddrahtverbindung auf dem Halbleiterchip um eine Zehnerpotenz bei gleichzeitig reduziertem Aufwand für den Korrosionsschutz verbessert werden kann.

### Kurze Beschreibung der Zeichnungen

Weitere Aspekte und Vorteile der Erfindung werden nunmehr anhand der beigefügten Figuren eingehender beschrieben. Hierbei zeigt:
- Fig. 1: eine schematische Darstellung eines elektronischen Bauteils gemäß einer Ausführungsform der Erfindung;
- Fig. 2: eine Darstellung von intermetallischen Phasen einer Gold-Bonddrahtverbindung auf einem Halbleiterchip;
- Fig. 3: einen Schliff durch eine korrosionsbelastete, ungeschützte Gold-Bonddrahtverbindung mit Markierung der korrodierten intermetallischen Phasen;
- Fig. 4: einen Schliff durch eine korrosionsgeschützte Gold-Bonddrahtverbindung des elektronischen Bauteils der Ausführungsform gemäß Figur 1.

### Ausführungsformen der Erfindung

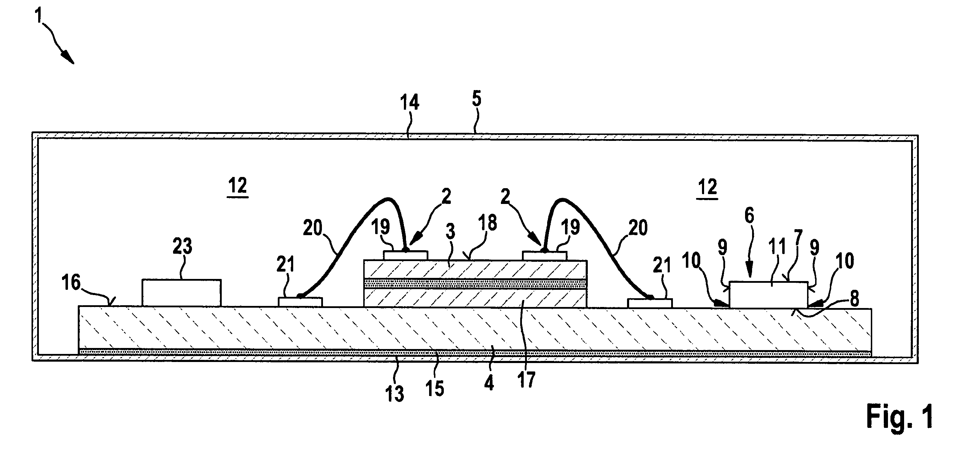

Die in Figur 1 gezeigte schematische Darstellung eines elektronischen Bauteils 1 gemäß einer Ausführungsform der Erfindung zeigt ein geschlossenes Gehäuse 5 mit einem Bodenbereich 13 und einem Abdeckbereich 14, wobei der Bodenbereich 13 mit dem Abdeckbereich 14 derart gefügt ist, dass sich ein hermetisch geschlossener Innenraum 12 in dem Gehäuse 5 ergibt. Auf dem Bodenbereich 13 ist mithilfe einer wärmeleitenden Silikonklebstoffschicht 15 ein Substrat 4 aus einer Keramiksubstanz fixiert. Von derartigen Silikonklebstoffschichten 15 ist es bekannt, dass sie bei Temperaturen oberhalb der Raumtemperatur Wassermoleküle in die Atmosphäre des Innenraums 12 emittieren können. Auf einer Oberseite 16 des Substrats 4 ist ein ungehäuster Halbleiterchip 3 mithilfe eines mit silberhaltigen Füllstoffpartikeln gefüllten Epoxidklebers 17 elektrisch leitend fixiert.

Auf einer Oberseite 18 des Halbleiterchips 3 sind Aluminium-Bondflächen 19 aus einer beispielsweise 4 Gew. % siliziumhaltigen Aluminium-Legierung angeordnet, auf denen eine Gold-Bonddrahtverbindung 2 thermokompressionsgebondet ist. Von der Bonddrahtverbindung 2 geht ein Goldbonddraht 20 mit einem Durchmesser zwischen 12 µm bis 50 µm aus und ist mit einem zweiten Ende auf einer Bondfläche 21 mit Goldmetallisierung einer Kupferleiterbahn auf der Oberseite 16 des Substrats 4 fixiert. Die Bonddrahtverbindung 2 auf dem Halbleiterchip 3 ist korrosionsgefährdet, wenn zusätzlich zu einer Wassermoleküle emittierenden Quelle auch eine Halogenide emittierende Störquelle 23 innerhalb des Gehäuses vorhanden ist, so dass sich korrosionsverursachende Elektrolyte bilden können. Um die Bonddrahtverbindung 2 vor einer derartigen Korrosion zu schützen, ist auf der Oberseite 16 des Substrats 4 ein oberflächenmontierbares elektrolyseempfindliches Bauelement 6 angeordnet, das eine Oberseite 7 und eine oberflächenmontierbare Unterseite 8 aufweist.

Zwischen der Oberseite 7 und der Unterseite 8 ist eine Randfläche 9 angeordnet. Für eine Oberflächenmontage ist mindestens eine molekulare Schicht 10 vorgesehen, die stoffschlüssig das hydrolyseempfindliche Bauelement 6 mit der Oberseite 16 des Substrats 4 verbindet. Das hydrolyseempfindliche Bauelement 6 weist ein Kernmaterial 11 aus einem hydrolyseempfindlichen Material auf, das in dieser Ausführungsform der Erfindung ein Polyester in Form eines Polybutylenterephthalat ist, welches durch die Aufnahme von Wassermolekülen verseift und somit die Atmosphäre des Innenraums 12 des Bauteils 1 an Wassermolekülen verarmt, so dass eine Elektrolytbildung mit Resthalogeniden unterbunden ist. Das Kernmaterial 11 aus einem Polybutylenterephthalat übt somit eine Getterwirkung auf die Wassermoleküle der Gasatmosphäre des Innenraums 12 aus, so dass auf teure alternative Getterschichten oder auf das Auffüllen mit Edelgasen für derartige elektronische Bauteile verzichtet werden kann.

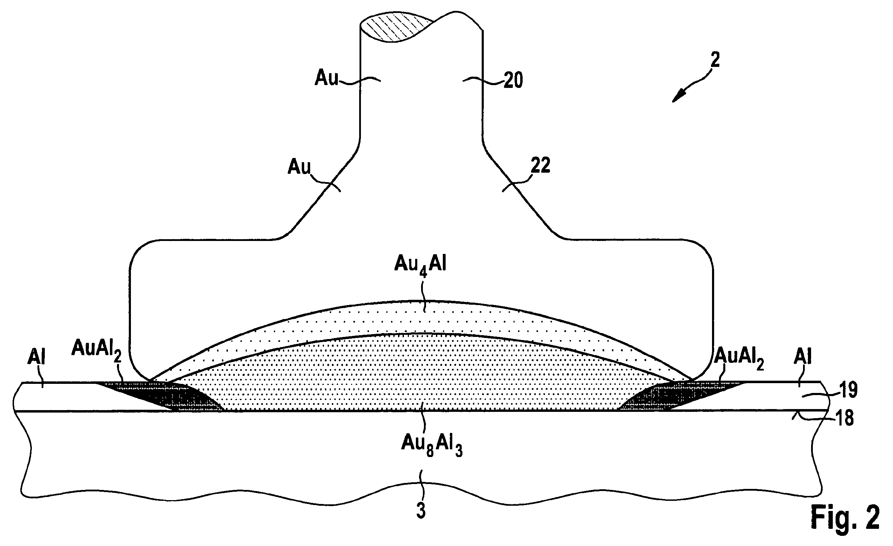

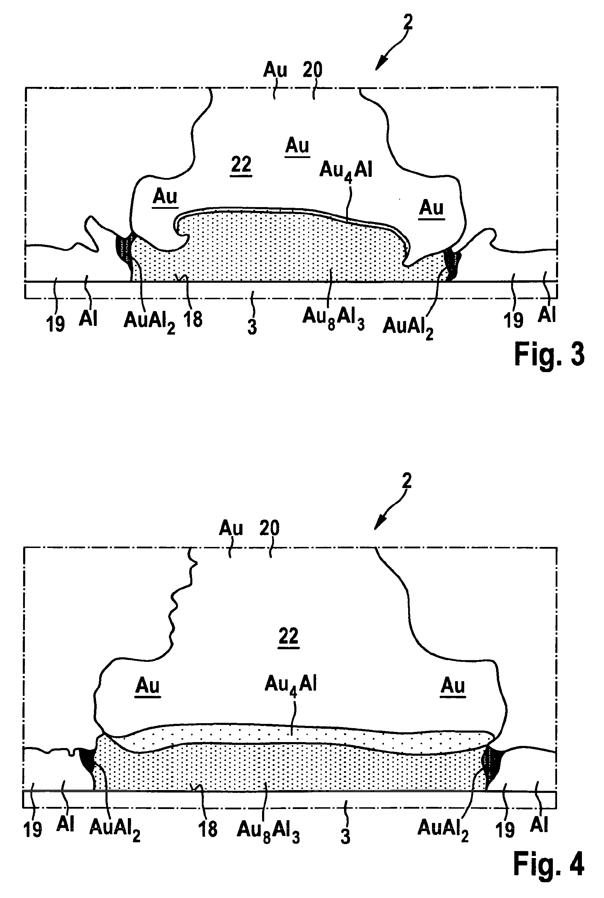

Figur 2 zeigt eine schematische Darstellung von intermetallischen Phasen einer thermokompressionsgebondeten Golddrahtverbindung auf einer Aluminium-Bondfläche 19 einer Oberseite 18 eines Halbleiterchips 3. Zunächst ist in Figur 2 die typische Nagelkopfform 22 zu sehen, die beim Thermokompressionsbonden entsteht, wobei sich der runde Golddraht 20 mit einem Durchmesser zwischen 12 und 50 Mikrometern aufgrund einer zwischenzeitlich gebildeten, an dem Golddraht 20 hängenden Schmelzperle aus Gold beim Aufpressen auf die Aluminium-Bondfläche 19 zu der typische Nagelkopfform 22 verformt. Deshalb wird dieses Bondverfahren auch "nail-head-bonding" genannt. Dabei entstehen im Übergang von der Nagelkopfform 22 zu der Aluminium-Bondfläche 19 eine erste intermetallische Phase aus Au₄Al und darunter eine zweite intermetallische Phase Au₈Al₃, die praktisch die gesamte Dicke der Aluminium-Bondfläche aufbraucht. Rings um die Nagelkopfform 22 bildet sich im Übergang zu der Aluminium-Bondfläche 19 eine dritte aluminiumreiche intermetallische Phase AuAl₂ aus. Diese thermokompressionsgebondete Bonddrahtverbindung zwischen einem Golddraht 20 und der Aluminium-Bondfläche 19 ist korrosionsgefährdet, was mit Figur 3 gezeigt wird.

Figur 3 zeigt einen Schliff durch eine korrosionsbelastete, ungeschützte Gold-Bonddrahtverbindung 2 mit Markierung der korrodierten intermetallischen Phasen. Von der ursprünglich in Figur 2 gezeigten Nadelkopfform 22 ist nicht mehr viel übrig, sie ist vielmehr zerklüftet und droht zumindest im linken Bereich der Figur 3 am Übergang zur Aluminiumbeschichtung bereits zu unterbrechen. Ein derartiger Korrosionsvorgang ist abhängig von der Betriebsdauer und begrenzt diese auf eine relativ kurze Lebensdauer für das elektronische Bauteil. Dabei sind auch hier durch die unterschiedlich dunklen Bereiche die intermetallische erste Phase Au₄Al im Übergang von dem aus Gold zusammengesetzten Nagelkopf 22 zu der Aluminium-Bondfläche 19 zu erkennen, und auch die zweite intermetallischen Phase Au₈Al₃ unmittelbar auf der Siliziumoberfläche sowie die den Nagelkopf 22 umgebende aluminiumreiche dritte metallische Phase AuAl₂ sind noch vorhanden.

Demgegenüber zeigt Figur 4 einen Schliff durch eine korrosionsgeschützte Gold-Bonddrahtverbindung 2 mit Markierung der intakten intermetallischen Phasenstruktur in einem elektronischen Bauteil der Ausführungsform der Erfindung gemäß Figur 1. Sowohl die Nagelkopfkontur in dem Übergangsbereich vom Golddraht 20 zu dem Nagelkopf 22 ist nach einer zehnfachen Testzeit gegenüber dem Ergebnis in Figur 3 noch unverändert erhalten und auch die übrigen Bereiche der intermetallischen Gold-Aluminiumphasen sind auf der Aluminium-Bondfläche 19 noch vollständig intakt.

## Patentansprüche

1. Elektronisches Bauteil mit korrosionsgeschützter Bondverbindung aufweisend:
- mindestens einen Halbleiterchip (3) auf einem Substrat (4);
- mindestens eine korrosionsgefährdete Bondverbindung auf dem Halbleiterchip (3);
- ein den mindestens einen Halbleiterchip (3) und die mindestens eine korrosionsgefährdete Bondverbindung hermetisch einschließendes Gehäuse (5),
wobei die Bondverbindung eine Bonddrahtverbindung (2) ist, und wobei die Bonddrahtverbindung (2) vollständig und das Substrat (4) mindestens teilweise in dem Gehäuse (5) hermetisch eingeschlossen ist, und wobei auf dem Substrat (4) mindestens ein oberflächenmontierbares hydrolyseempfindliches Bauelement (6) angeordnet ist, und das hydrolyseempfindliche Bauelement (6) ein hydrolyseempfindliches Kernmaterial (11) aufweist, wobei das Kernmaterial (11) Wassermoleküle einer Atmosphäre eines Innenraumes (12) des Gehäuses (5) geltern kann, wobei das Kernmaterial (11) des hydrolyseempfindlichen Bauelements (6) eine semipermeable Beschichtung mindestens auf der Oberseite (7) und der Randfläche (9) des hydrolyseempfindlichen Bauelements (6) aufweist, und wobei die semipermeable Beschichtung die Form des hydrolyseempfindlichen Bauelements (6) bei Vesseifung und Fernverlust stützt und für Wassermoleküle permeabel ist.

2. Elektronisches Bauteil nach Anspruch 1, wobei das hydrolyseempfindliche Bauelement (6) eine Oberseite (7), eine Unterseite (8) und eine zwischen Oberseite (7) und Unterseite (8) angeordnete Randfläche (9) aufweist, und wobei die Unterseite (8) des hydrolyseempfindlichen Bauelements (6) eine oberflächenmontierbare Molekularlage (10) aufweist.

3. Elektronisches Bauteil nach einem der vorhergehenden Ansprüche, wobei das hydrolyseempfindliche Bauelement (6) einen hydrolyseempfindlichen Kunststoff aufweist.

4. Elektronisches Bauteil nach Anspruch 3, wobei der Kunststoff ein hydrolyseempfindliches Polymer, das bei seiner Hydrolyse dem Innenraum (12) des Gehäuses (5) Wassermoleküle entzieht, aufweist.

5. Elektronisches Bauteil nach Anspruch 3 oder Anspruch 4, wobei der hydrolyseempfindliche Kunststoff eine intensive Verseifung durch Hydrolyse bei Überschreiten einer Glasübergangstemperatur des Kunststoffs aufweist.

6. Elektronisches Bauteil nach einem der Ansprüche 3 bis 5, wobei der Kunststoff ein hydrolyseempfindlicher Polyester ist.

7. Elektronisches Bauteil nach einem der Ansprüche 3 bis 6, wobei der Kunststoff ein hydrolyseempfindliches Polybutylenterephthalat ist.

8. Verfahren zur Herstellung eines elektronischen Bauteils (1) gemäß einem der vorhergehenden Ansprüche, das nachfolgende Verfahrenschritte aufweist:
- Herstellen mindestens eines Halbleiterchips (3);
- Aufbringen des mindestens einen Halbleiterchips (3) auf ein Substrat (4);
- Herstellen mindestens einer Bonddrahtverbindung (2) zwischen dem mindestens einen Halbleiterchip (3) und dem Substrat (4);
- Oberflächenmontieren mindestens eines Bauelements (6) mit einem hydrolyseempfindlichen Material auf dem Substrat (4);
- hermetisches Einkapseln des mindestens einen Halbleiterchips (3), der mindestens einen Bonddrahtverbindung (2), des mindestens einen Bauelements (6) mit dem hydrolyseempfindlichen Material und mindestens teilweise des Substrats (4) in ein Gehäuse (5);
- Tempern des elektronischen Bauteils (1) bei einer Temperatur über einer Glasumwandlungstemperatur des hydrolyseempfindlichen Materials unter Gettern von Wassermolekülen einer Atmosphäre eines Innenraums (12) des Gehäuses (5),
wobei das hydrolyseempfindliche Bauelement (6) ein hydrolyseempfindliches Kernmaterial (11) aufweist, wobei das Kernmaterial (11) des hydrolyseempfindlichen Bauelements (6) eine semipermeable Beschichtung mindestens auf der Oberseite (7) und der Randfläche (9) des hydrolyseempfindlichen Bauelements (6) aufweist, und wobei die semipermeable Beschichtung die Form des hydrolyseempfindlichen Bauelements (6) bei Verseifung und Formverlust stützt und für Wassermoleküle permeabel ist.

## Claims

1. Electronic component having a corrosion-protected bonding connection, comprising:
- at least one semiconductor chip (3) on a substrate (4);
- at least one bonding connection at risk of corrosion on the semiconductor chip (3);
- a package (5) hermetically enclosing the at least one semiconductor chip (3) and the at least one bonding connection at risk of corrosion,
the bonding connection being a bonding wire connection (2), and the bonding wire connection (2) being completely hermetically enclosed in the package (5) and the substrate (4) being at least partially hermetically enclosed in the package (5), and at least one surface-mountable hydrolysis-sensitive component (6) being arranged on the substrate (4), and the hydrolysis-sensitive component (6) comprising a hydrolysis-sensitive core material (11), the core material (11) being able to getter water molecules of an atmosphere of an interior space (12) of the package (5), the core material (11) of the hydrolysis-sensitive component (6) having a semipermeable coating at least on the upper side (7) and the peripheral surface (9) of the hydrolysis-sensitive component (6), and the semipermeable coating supporting the form of the hydrolysis-sensitive component (6) during saponification and loss of form and being permeable to water molecules.

2. Electronic component according to Claim 1, the hydrolysis-sensitive component (6) having an upper side (7), an underside (8) and a peripheral surface (9) arranged between the upper side (7) and the underside (8), and the underside (8) of the hydrolysis-sensitive component (6) having a surface-mountable molecular layer (10).

3. Electronic component according to either of the preceding claims, the hydrolysis-sensitive component (6) comprising a hydrolysis-sensitive plastic.

4. Electronic component according to Claim 3, the plastic comprising a hydrolysis-sensitive polymer, which in its hydrolysis extracts water molecules from the interior space (12) of the package (5).

5. Electronic component according to Claim 3 or Claim 4, the hydrolysis-sensitive plastic having intensive saponification by hydrolysis when a glass transition temperature of the plastic is exceeded.

6. Electronic component according to one of Claims 3 to 5, the plastic being a hydrolysis-sensitive polyester.

7. Electronic component according to one of Claims 3 to 6, the plastic being a hydrolysis-sensitive polybutylene terephthalate.

8. Method for producing an electronic component (1) according to one of the preceding claims, which comprises the following method steps:
- producing at least one semiconductor chip (3);
- applying the at least one semiconductor chip (3) to a substrate (4);
- establishing at least one bonding wire connection (2) between the at least one semiconductor chip (3) and the substrate (4);
- surface-mounting at least one component (6) with a hydrolysis-sensitive material on the substrate (4);
- hermetically encapsulating the at least one semiconductor chip (3), the at least one bonding wire connection (2), the at least one component (6) with the hydrolysis-sensitive material and at least partially the substrate (4) in a package (5);
- heat-treating the electronic component (1) at a temperature above a glass transition temperature of the hydrolysis-sensitive material, with gettering of water molecules of an atmosphere of an interior space (12) of the package (5), the hydrolysis-sensitive component (6) comprising a hydrolysis-sensitive core material (11), the core material (11) of the hydrolysis-sensitive component (6) having a semipermeable coating at least on the upper side (7) and the peripheral surface (9) of the hydrolysis-sensitive component (6), and the semipermeable coating supporting the form of the hydrolysis-sensitive component (6) during saponification and loss of form and being permeable to water molecules.

## Revendications

1. Composant électronique comprenant une liaison de connexion protégée contre la corrosion, comprenant :
- au moins une puce en semiconducteur (3) sur un substrat (4) ;
- au moins une liaison de connexion menacée par la corrosion sur la puce en semiconducteur (3) ;
- un boîtier (5) qui enferme hermétiquement ladite puce en semiconducteur (3) et ladite liaison de connexion menacée par la corrosion,
la liaison de connexion étant une liaison par fil de connexion (2) et la liaison par fil de connexion (2) étant entièrement enfermée hermétiquement, et le substrat (4) au moins partiellement enfermé hermétiquement, dans le boîtier (5), et au moins un élément structural (6) sensible à l'hydrolyse pouvant être monté en surface étant disposé sur le substrat (4) et l'élément structural (6) sensible à l'hydrolyse possédant un matériau de coeur (11) sensible à l'hydrolyse, le matériau de coeur (11) pouvant dégazer les molécules d'eau d'une atmosphère d'un espace intérieur (12) du boîtier (5), le matériau de coeur (11) de l'élément structural (6) sensible à l'hydrolyse possédant un revêtement semi-perméable au moins sur le côté supérieur (7) et la surface de bordure (9) de l'élément structural (6) sensible à l'hydrolyse, et le revêtement semi-perméable soutenant la forme de l'élément structural (6) sensible à l'hydrolyse lors d'une saponification et d'une perte de forme et étant 4 perméable aux molécules d'eau.

2. Composant électronique selon la revendication 1, dans lequel l'élément structural (6) sensible à l'hydrolyse possède un côté supérieur (7), un côté inférieur (8) et une surface de bordure (9) disposée entre le côté supérieur (7) et le côté inférieur (8), et le côté inférieur (8) de l'élément structural (6) sensible à l'hydrolyse possédant une couche moléculaire (10) pouvant être montée en surface.

3. Composant électronique selon l'une des revendications précédentes, dans lequel l'élément structural (6) sensible à l'hydrolyse possède une matière plastique sensible à l'hydrolyse.

4. Composant électronique selon la revendication 3, dans lequel la matière plastique possède un polymère sensible à l'hydrolyse qui, lors de son hydrolyse, soutire des molécules d'eau de l'espace intérieur (12) du boîtier (5).

5. Composant électronique selon la revendication 3 ou la revendication 4, dans lequel la matière plastique sensible à l'hydrolyse présente une saponification intensive par l'hydrolyse en cas de dépassement d'une température de transition vitreuse de la matière plastique.

6. Composant électronique selon l'une des revendications 3 à 5, dans lequel la matière plastique est un polyester sensible à l'hydrolyse.

7. Composant électronique selon l'une des revendications 3 à 6, dans lequel la matière plastique est un polytéréphtalate de butylène sensible à l'hydrolyse.

8. Procédé de fabrication d'un composant électronique (1) selon l'une des revendications précédentes, lequel procédé comprend les étapes suivantes :
- fabrication d'au moins une puce en semiconducteur (3) ;
- apposition de ladite puce en semiconducteur (3) sur un substrat (4) ;
- fabrication d'au moins une liaison par fil de connexion (2) entre ladite puce en semiconducteur (3) et le substrat (4) ;
- montage en surface d'au moins un élément structural (6) ayant un matériau sensible à l'hydrolyse sur le substrat (4) ;
- encapsulation hermétique de ladite puce en semiconducteur (3), de ladite liaison par fil de connexion (2), dudit élément structural (6) ayant le matériau sensible à l'hydrolyse et au moins partiellement du substrat (4) dans un boîtier (5) ;
- traitement thermique du composant électronique (1) à une température supérieure à une température de transition vitreuse du matériau sensible à l'hydrolyse en dégazant les molécules d'eau d'une atmosphère d'un espace intérieur (12) du boîtier (5),
l'élément structural (6) sensible à l'hydrolyse possédant un matériau de coeur (11) sensible à l'hydrolyse, le matériau de coeur (11) de l'élément structural (6) sensible à l'hydrolyse possédant un revêtement semi-perméable au moins sur le côté supérieur (7) et la surface de bordure (9) de l'élément structural (6) sensible à l'hydrolyse, et le revêtement semi-perméable soutenant la forme de l'élément structural (6) sensible à l'hydrolyse lors d'une saponification et d'une perte de forme et étant perméable aux molécules d'eau.
